# EUROPÄISCHE PATENTSCHRIFT

(11) **EP 4 107 784 B1**
(45) Veröffentlichungstag und Bekanntmachung des Hinweises auf die Patenterteilung: **10.04.2024**
(21) Anmeldenummer: 21706208.2
(22) Anmeldetag: 15.02.2021
(51) Int. Cl.: H01L 29/40, H01L 29/66, H01L 29/78, H01L 29/16, H01L 29/20, H01L 29/06

(54) **VERTIKALER FIN-FELDEFFEKTTRANSISTOR, VERTIKALE FIN-FELDEFFEKTTRANSISTOR-ANORDNUNG UND VERFAHREN ZUM BILDEN EINES VERTIKALEN FIN-FELDEFFEKTTRANSISTORS**
VERTICAL FIN FIELD EFFECT TRANSISTOR, VERTICAL FIN FIELD EFFECT TRANSISTOR ARRANGEMENT, AND METHOD FOR FORMING A VERTICAL FIN FIELD EFFECT TRANSISTOR
TRANSISTOR À EFFET DE CHAMP À AILETTE VERTICALE, AGENCEMENT DE TRANSISTOR À EFFET DE CHAMP À AILETTE VERTICALE ET PROCÉDÉ DE FORMATION DE TRANSISTOR À EFFET DE CHAMP À AILETTE VERTICALE

(30) Priorität: 18.02.2020 DE 102020202038
(43) Veröffentlichungstag der Anmeldung: 28.12.2022
(73) Patentinhaber: Robert Bosch GmbH, 70442 Stuttgart (DE)
(72) Erfinder: MARTINEZ-LIMIA, Alberto, 72072 Tuebingen (DE); BARINGHAUS, Jens, 71069 Sindelfingen (DE); RUDHARD, Joachim, 70771 Leinfelden-Echterdingen (DE); FEILER, Wolfgang, 72770 Reutlingen (DE); KREBS, Daniel, 70597 Stuttgart (DE)
(86) Internationale Anmeldenummer: PCT/EP2021/053596
(87) Internationale Veröffentlichungsnummer: WO 2021/165183

(56) Entgegenhaltungen:
- US-A1- 2005 161 732
- US-A1- 2014 015 036

## Beschreibung

Die Erfindung betrifft einen vertikalen Fin-Feldeffekttransistor (FinFET), eine vertikale Fin-Feldeffekttransistor-Anordnung und ein Verfahren zum Bilden eines vertikalen Fin-Feldeffekttransistors.

Für die Anwendung von Halbleitern mit breitem Bandabstand (z.B. SiC oder GaN) in der Leistungselektronik kommen typischerweise Leistungs-MOSFETs mit vertikalem Kanalgebiet zum Einsatz. Das Kanalgebiet ist dabei angrenzend an einen Graben (Trench) gebildet, so dass diese Art von MOSFET auch als Trench-MOSFET (TMOSFET) bezeichnet wird. Durch geeignete Wahl von Geometrie und Dotierungskonzentrationen von Epitaxie-, Kanal- und Abschirmbereichen können ein relativ niedriger Einschaltwiderstand und eine relativ hohe Durchbruchspannung erzielt werden.

Gemäß dem Stand der Technik weist ein Leistungs-Trench-MOSFET eine tiefe p⁺ Implantation als Abschirmbereich und einen Trench auf, welche periodisch abwechselnd zu einem Zellenfeld aus mehreren einzelnen MOSFETs, die auch als Zellen bezeichnet werden, zusammengesetzt werden. Proportionen von Trench, p⁺ Abschirmbereich und einem dazwischen gebildeten, mittels eines isolierten Gates schaltbaren Kanalgebiet ergeben sich aus Forderungen, einen möglichst geringen Einschaltwiderstand, eine möglichst niedrige maximale Feldbelastung am Gatedielektrikum, einen möglichst geringen Sättigungsstrom im Kurzschlussfall und eine möglichst hohe Durchbruchspannung zu erzielen. Ein Abstand zwischen gleichartigen Strukturen benachbarter MOSFETs (Pitch) ist dabei begrenzt durch die technischen Möglichkeiten, den Trench zu bilden, die verschiedenen Gebiete zu kontaktieren und die p⁺ Implantation zu realisieren. Das Dokument US2014/015036 A1 offenbart einen vertikalen Silizium-Fin-Transistor mit n-dotierten Source/Drain-Bereichen, einem Kanalbereich in der Finne und einem Gate-Bereich, der durch ein Gate-Dielektrikum vom Kanalbereich isoliert ist. Der Transistor umfasst außerdem einen p-dotierten Gate-Abschirmbereich unter dem Gate-Bereich, der über einen leitfähigen Bereich mit der Source elektrisch verbunden ist.

Ein Kanalwiderstand des TMOSFETs ist bestimmt durch die Ladungsträgerverteilung im Kanal und deren Mobilität. Diese beiden Größen werden maßgeblich durch Grenzflächenladungen an einer Grenzfläche zwischen dem Halbleitermaterial im Kanalgebiet und dem Gatedielektrikum bzw. durch Ladungen im Gatedielektrikum und durch die Kanaldotierung bestimmt. Der Zell-Pitch ist maßgeblich bestimmt durch den p⁺ Abschirmbereich, da zu seiner Herstellung Hochenergie-Implantationen benötigt werden, die wiederum eine ausreichend dicke Maske voraussetzen. Die Dicke dieser Maske limitiert die kleinste Dimension, welche geöffnet werden kann, und darüber den Zell-Pitch.

In verschiedenen Ausführungsbeispielen wird ein vertikaler Fin-Feldeffekttransistor (vertikaler FinFET, kurz: FinFET; bei einem FinFET besteht die schaltfähige Komponente aus einer schmalen Halbleiter-Finne) mit Trench-Kontakt für eine Abschirmstruktur bereitgestellt. Anschaulich beschrieben ist bei dem vertikalen Fin-Feldeffekttransistor die Abschirmstruktur direkt unterhalb des Grabens angeordnet und mit einem im Graben gebildeten elektrisch leitfähigen Kontakt elektrisch leitfähig verbunden.

Durch seine Geometrie und durch eine geeignete Wahl von Material und Herstellungsprozess des Gatedielektrikums kann ein besonders geringer Kanalwiderstand ermöglicht werden.

Die Kontaktierung der Abschirmstruktur durch den Trench kann einen besonders geringen Zellpitch ermöglichen.

Der FinFET kann beispielsweise als Leistungs-FinFET (Power-FinFET) verwendet werden. Demzufolge kann in verschiedenen Ausführungsbeispielen ein Einschaltwiderstand des Power-FinFETs mit Trench Kontakt deutlich geringer sein als bei einem MOSFET oder MISFET auf Basis von Siliziumcarbid (SiC) oder Galliumnitrid (GaN) gemäß dem Stand der Technik. Hieraus resultieren geringere Verluste im Betrieb des gesamten Bauteils.

In verschiedenen Ausführungsbeispielen wird ein Leistungs-FinFET mit einem Trenchkontakt zu einer Abschirmstruktur bereitgestellt. Dimensionen, Dotierungen und Grenzflächenladungen an einem Gatedielektrikum (z.B. Gateoxid) können - wie unten näher ausgeführt - so eingerichtet sein, dass ein niedriger Einschaltwiderstand, eine hohe Durchbruchspannung, ein geringer Kurzschlussstrom und eine niedrige maximale Feldbelastung am Gatedielektrikum erzielt werden.

Ferner wird ein Verfahren bereitgestellt, einen solchen FinFET zu bilden, wobei eine relative Positionierung des Trenches und der Abschirmstruktur selbstjustiert erfolgt. Das bedeutet, dass bei einfacher Herstellung eine hohe relative Positionierungsgenauigkeit erzielbar ist.

Weiterbildungen der Aspekte sind in den Unteransprüchen und der Beschreibung dargelegt. Ausführungsformen der Erfindung sind in den Figuren dargestellt und in der nachfolgenden Beschreibung näher erläutert. Es zeigen:
- Figur 1: eine schematische Querschnittsansicht eines vertikalen FinFETs gemäß verschiedenen Ausführungsbeispielen;
- Figur 2A: eine Veranschaulichung von Schwellspannungen in FinFETs in Abhängigkeit von einer Kanaldotierungskonzentration und einer Grenzflächenladung;
- Figur 2B: eine Veranschaulichung von Einschaltwiderständen in FinFETs in Abhängigkeit von einer Kanaldotierungskonzentration und einer Grenzflächenladung;
- Figur 3A: eine Stromdichte und eine kumulierte Stromdichte in Abhängigkeit von einem Abstand von einer SiC/Oxid Grenzfläche in einem FinFET;
- Figur 3B: eine Stromdichte und eine kumulierte Stromdichte in Abhängigkeit von einem Abstand von einer SiC/Oxid Grenzfläche in einem FinFET gemäß verschiedenen Ausführungsbeispielen;
- Figur 3C: eine Elektronenmobilität, eine Elektronendichte und eine Leitfähigkeit in Abhängigkeit von einem Abstand von einer SiC/Oxid Grenzfläche in einem FinFET;
- Figur 3D: eine Elektronenmobilität, eine Elektronendichte und eine Leitfähigkeit in Abhängigkeit von einem Abstand von einer SiC/Oxid Grenzfläche in einem FinFET gemäß verschiedenen Ausführungsbeispielen;
- Figuren 4A bis 4S: eine schematische Veranschaulichung eines Verfahrens zum Bilden eines vertikalen FinFETs gemäß verschiedenen Ausführungsbeispielen;
- Figur 5: eine schematische perspektivische Vorder- und Rückseitenansicht eines FinFETs gemäß verschiedenen Ausführungsbeispielen; und
- Figur 6: ein Ablaufdiagramm eines Verfahrens zum Bilden eines vertikalen FinFETs gemäß verschiedenen Ausführungsbeispielen.

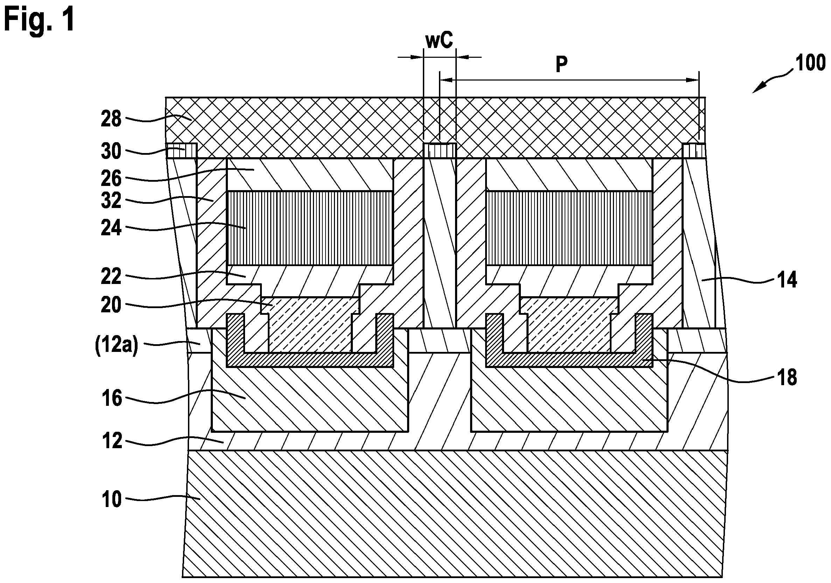

In FIG. 1 ist eine schematische Querschnittsansicht eines vertikalen FinFETs 100 gemäß verschiedenen Ausführungsbeispielen dargestellt.

Der vertikale Fin-Feldeffekttransistor 100 kann eine n-dotierte Halbleiter-Finne 14 (kurz: Finne) aufweisen, welche sich vertikal zwischen einem n-dotierten Sourcebereich 30 (oberhalb oder im oberen Ende der Finne 14) und einem n-dotierten Driftbereich 10, 12 (unterhalb der Finne 14) des FinFETs erstrecken kann. Der Driftbereich 10, 12 kann ein n-dotiertes Driftgebiet 10 und ein n-dotiertes Ausbreitungsgebiet (Spreadinggebiet) 12 aufweisen. Eine Dotierungskonzentration kann in verschiedenen Ausführungsbeispielen im Spreadinggebiet 12 höher sein als im darunter angeordneten Driftgebiet 10, und höher sein als im darüber angeordneten n-Kanalgebiet in der Halbleiter-Finne 14. Bei einem Ausführungsbeispiel können die Dotierungen zum Beispiel 10¹⁶ cm⁻³ im Driftgebiet 10, 10¹⁷ cm⁻³ im Spreadinggebiet 12 und 4.10¹⁶ cm⁻³ im Kanalgebiet in der Finne 14 sein. Das n-dotierte Halbleitermaterial des Driftbereichs 10, 12 und der Finne 14 kann als epitaktisch aufgewachsenes Material bereitgestellt sein bzw. werden, z.B. aufgewachsen auf einem Substrat, ggf. mit zwischen dem Driftbereich 10, 12 und dem Substrat angeordneter Pufferschicht. Auf einer Rückseite des Substrats kann ein Drainkontakt angeordnet sein. Substrat, Drainkontakt und ggf. Pufferschicht können auf bekannte oder im Wesentlichen bekannte Weise hergestellt sein.

Der vertikale Fin-Feldeffekttransistor 100 kann ferner mindestens einen dem Kanalbereich horizontal benachbarten Gatebereich 24 aufweisen. Im Ausführungsbeispiel aus FIG. 1 sind horizontal benachbart zur Finne 14 zwei Gatebereiche 24 gebildet, welche von der Finne 14 durch ein Gatedielektrium 32 und von einem darüber angeordneten Sourcekontakt 28 mittels eines weiteren Dielektrikums 26 elektrisch isoliert sein können. Der Gatebereich 24 kann ein leitfähiges Material aufweisen, beispielsweise Poly-Silizium. In verschiedenen Ausführungsbeispielen kann an dessen Oberfläche mittels Re-Oxidation das weitere Dielektrikum 26 als Isolierung zum Sourcekontakt 28 gebildet werden.

An einer Grenzfläche zwischen dem Gatedielektrikum 32 und dem Kanalbereich 14 bzw. im Gatedielektrikum 32 selbst können negative Grenzflächenladungen vorliegen.

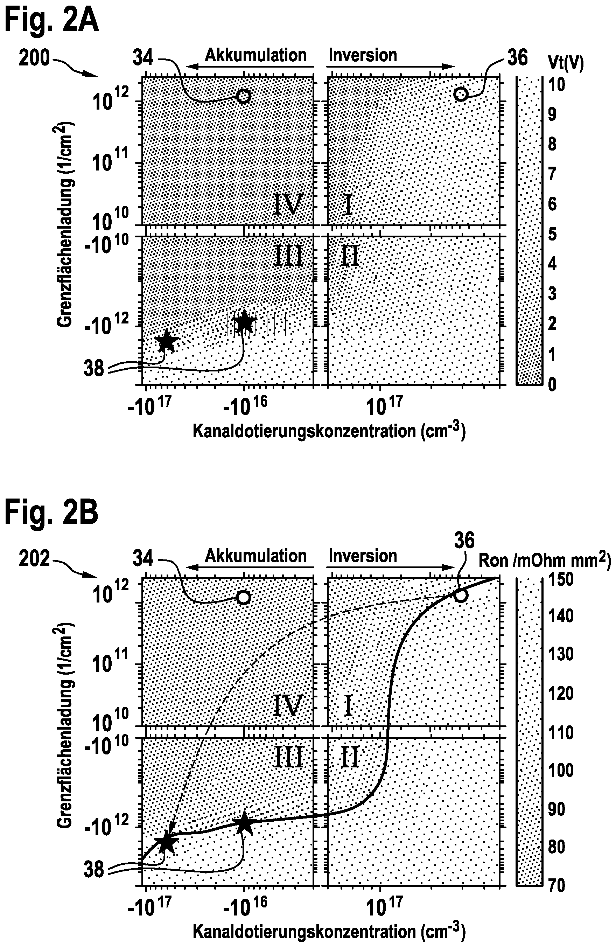

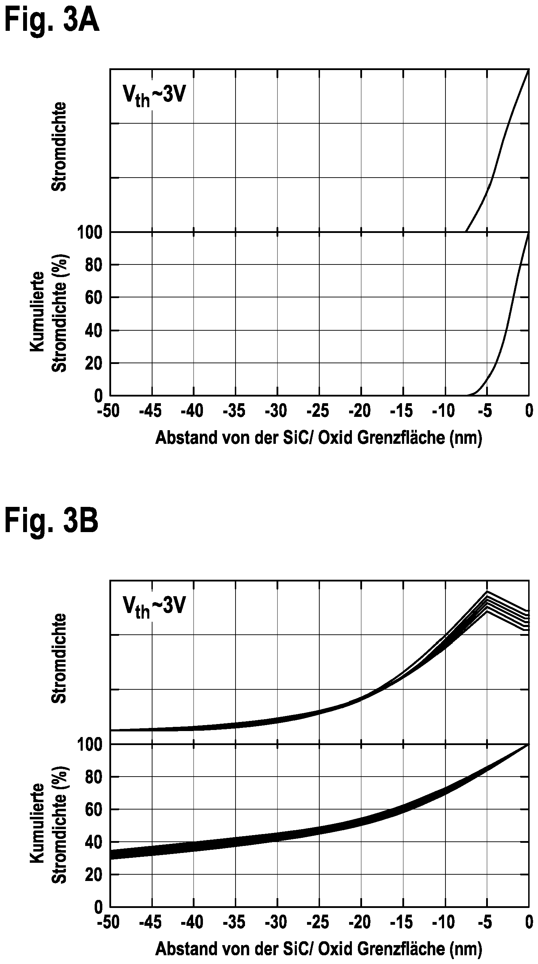

Eigenschaften eines FinFETS mit einer solchen Gestaltung 100 sind in FIG. 2A und 2B und in FIG. 3A bis 3D dargestellt.

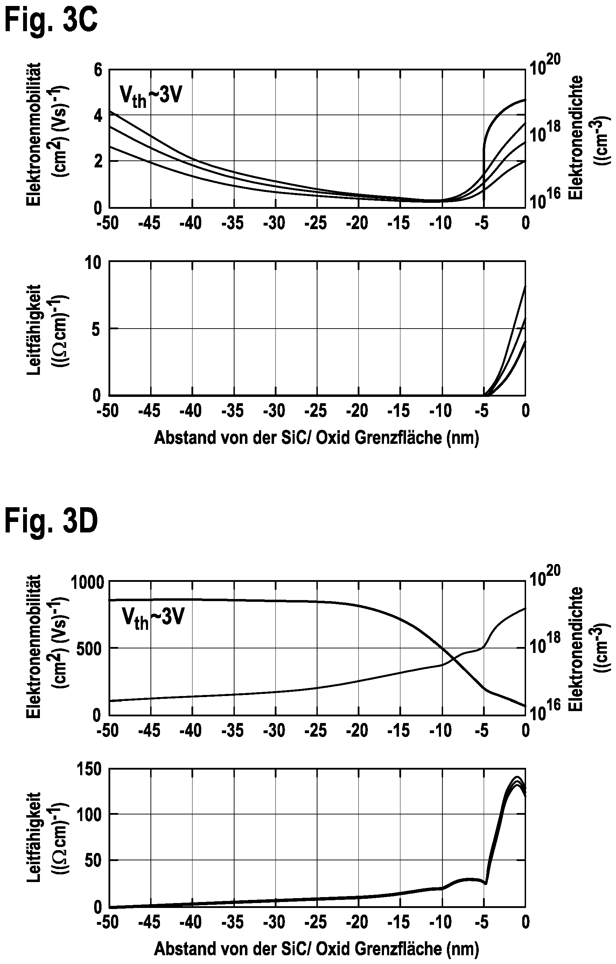

In FIG. 2A sind in einem Schaubild 200 Schwellspannungen Vt in FinFETs veranschaulicht in Abhängigkeit von einer Kanaldotierungskonzentration und einer Grenzflächenladung, FIG. 2B zeigt in einem Schaubild 202 eine Veranschaulichung von Einschaltwiderständen in FinFETs in Abhängigkeit von einer Kanaldotierungskonzentration und einer Grenzflächenladung, FIG. 3A zeigt eine Stromdichte (oben) und eine kumulierte Stromdichte (unten) in Abhängigkeit von einem Abstand von einer SiC/Oxid Grenzfläche in einem FinFET für den Fall von p Kanaldotierung und positiver Grenzflächenladung (Quadrant I in FIG. 2) wie der Kanal gemäß dem Stand der Technik für einen TMOSFET verwendet wird, FIG. 3B zeigt eine Stromdichte und eine kumulierte Stromdichte in Abhängigkeit von einem Abstand von der SiC/Oxid Grenzfläche in einem FinFET für den Fall von n Kanaldotierung und negativer Grenzflächenladung (Quadrant III in FIG. 2) gemäß verschiedenen Ausführungsbeispielen, FIG. 3C zeigt die zu FIG. 3A entsprechende Elektronenmobilität, Elektronendichte und Leitfähigkeit in Abhängigkeit von einem Abstand von der SiC/Oxid Grenzfläche, und FIG. 3D zeigt die zu FIG. 3B entsprechende Elektronenmobilität, Elektronendichte und Leitfähigkeit in Abhängigkeit von einem Abstand von einer SiC/Oxid Grenzfläche.

Der Kanalwiderstand kann signifikant verringert werden, wenn von einem p-dotierten Inversionskanal, wie er gemäß dem Stand der Technik verwendet wird und in FIG. 2A und FIG. 2B jeweils auf der rechten Seite, und in FIG. 3A und FIG. 3C dargestellt ist, zu einem n-dotiertem Akkumulationskanal übergegangen wird, welcher in FIG. 2A und FIG. 2B jeweils auf der linken Seite, und in FIG. 3B und FIG. 3D dargestellt ist.

In FIG. 2B ist eine Größe eines ON-Widerstands, also für einen FinFET im eingeschalteten Zustand, symbolisch dargestellt für ein Parameterfeld von Kanaldotierungen und Grenzflächenladungen des FinFETs mit 300 nm breiten Finnen und einem Zell-Pitch von 800 nm. Wird als Gateoxid ein in Stickoxidatmosphäre getempertes Siliziumdioxid verwendet (wie beim Stand der Technik), wird ein Inversionskanal mit positiver Grenzflächenladung gebildet. Das entspricht dem Kreis 36 im ersten Quadranten (rechts oben) in FIG. 2A und FIG. 2B. Wird stattdessen ein Akkumulationskanal mit positiver Grenzflächenladung gebildet (Kreis 34 im vierten Quadranten links oben), reduziert sich der ON-Widerstand um ca. einen Faktor zwei. Allerdings haben FinFETs mit n-Kanal Dotierung und positiver Grenzflächenladung eine Schwellspannung < 0V, wie in FIG. 2A links oben im vierten Quadranten zu sehen ist. Dies hängt damit zusammen, dass positive Grenzflächenladungen die Schwellspannung zu kleineren Werten hin verschiebt. Durch die Wahl eines Gatedielektrikums oder Gatedielektrikum-Stapels oder einer geeigneten Vor- oder Nach-Behandlungsmethode kann eine Grenzfläche Kanal-Halbleitermaterial/Gatedielektrikum mit negativen Grenzflächenladungen erzeugt werden oder negative Ladungen ins Gatedielektrikum eingebaut werden.

Das kann dazu führen, dass Kombinationen aus Grenzflächenladungen und Kanaldotierungen ermittelbar sind, die sowohl eine geeignete positive Schwellspannung (z.B. 3V, schwarze Linie in FIG. 2B) als auch einen geringeren ON-Widerstand liefern als ein FinFET mit einer SiC/Gatedielektrikum Grenzfläche gemäß dem Stand der Technik. Diese Kombinationen sind beispielsweise im zweiten und dritten Quadranten sowohl für Inversion (zweiter Quadrant) als auch für Akkumulation (dritter Quadrant) auffindbar, z.B. entlang der schwarzen Linie im zweiten bzw. dritten Quadranten.

Insbesondere FinFETs, die dem dritten Quadranten zuzuordnen sind, z.B. mit Parametern, die durch die beiden Sterne 38 dort markiert sind, weisen die oben beschriebenen Vorteile auf. Beim FinFET 100 gemäß verschiedenen Ausführungsbeispielen können die Grenzflächenladungen und die Kanaldotierungskonzentration gemäß den im dritten Quadranten dargestellten Simulationsergebnissen unter Berücksichtigung der gewünschten Schwellspannung gewählt werden, z.B. für 3V entlang der schwarzen Linie.

Als Gatedielektrikum 32 kann in verschiedenen Ausführungsbeispielen ein nassoxidiertes thermisches Oxid bei 1150°C verwendet werden, das ggf. mit einem NO-Tempern bei 1150°C nachbehandelt wird, oder ein Gatedielektrikums-Stapel aus SiO₂ und Si₃N₄ oder SiO₂ und Al₂O₃.

Wie oben erwähnt ist ein Grund für die Verringerung des ON-Widerstands die Ladungsträgerverteilung im Kanal und deren Mobilität. Dies wird anschaulich anhand eines Vergleichs von Stromdichten für Inversionskanäle (FIG. 3A, FIG. 3C) und Akkumulationskanäle (FIG. 3B, FIG. 3D) mit jeweils 3V Schwellspannung im Querschnitt der Finne 14.

Während die Stromdichte im Inversionskanal (FIG. 3A, FIG. 3C) ausschließlich in den ersten 5-10 nm zur SiC/Gate-Oxid Grenzfläche getragen wird, also nur dort signifikante Werte annimmt, geht die Stromverteilung im Akkumulationskanal (FIG. 3B, 3D) viel tiefer in die Finne 14 hinein. Dort ist, wie in FIG. 3C und 3D unten zu sehen ist, die Leitfähigkeit deutlich höher. Somit ergibt sich eine höhere Leitfähigkeit im Kanal, der sich nahezu über die gesamte Finnenbreite wC (siehe FIG. 1) erstreckt.

Der vertikale Fin-Feldeffekttransistor 100 kann ferner einen p-dotierten Gate-Abschirmbereich 16 aufweisen, welcher so unter dem Gatebereich 24 angeordnet ist, dass bei vertikaler Projektion der Gate-Abschirmbereich 16 zumindest teilweise, beispielsweise größtenteils, fast vollständig oder vollständig, z.B. mit mindestens 50%, mindestens 60%, mindestens 70%, mindestens 80%, mindestens 90% oder mindestens 95% seiner projizierten Fläche, innerhalb einer vom Gatedielektrikum 32 begrenzten Fläche liegt. Der Gate-Abschirmbereich 16 kann dazu dienen, das Gatedielektrikum 32 am Trenchboden vor zu großen elektrischen Feldern abzuschirmen.

Der Sourcekontakt 28 kann elektrisch leitend mit dem Sourcebereich 30 verbunden sein, und ein elektrisch leitfähiger Bereich 18, 20 kann zwischen dem Gatebereich 24 und dem p-dotierten Gate-Abschirmbereich 16 angeordnet sein, wobei der p-dotierte Gate-Abschirmbereich 16 mittels des elektrisch leitfähigen Bereichs 18, 20 mit dem Sourcekontakt 28 elektrisch leitfähig verbunden sein kann.

Ein zweiter Parameter, welcher den Kanalwiderstand beeinflussen kann, ist der Zellabstand (Pitch) P, wobei ein kleinerer Pitch P den Kanalwiderstand verkleinert.

Gemäß dem Stand der Technik wird ein Abschirmbereich typischerweise mittels einer tiefen p-Implantation verwirklicht. Für diese Implantation wird eine relativ (z.B. ca. 1,5 µm) dicke Oxidmaske benötigt, welche die kleinste Öffnung, die erreicht werden kann - und damit den Pitch P - begrenzt.

In verschiedenen Ausführungsbeispielen wird ein Herstellungsverfahren für einen FinFET 100 mit verkleinertem Zell-Pitch P bereitgestellt. Bei dem Verfahren wird eine Abschirmstruktur bereitgestellt, indem der den Zell-Pitch begrenzende Lithographievorgang nicht zwischen zwei Trenches ausgeführt wird, sondern der Gate-Abschirmbereich 16 unterhalb des Trenches ausgebildet wird.

In verschiedenen Ausführungsbeispielen kann dieselbe Maske für die Trenchbildung und für die Abschirmungsimplantation genutzt werden. Das heißt, zunächst werden die Trenches gebildet, und anschließend in die Trenches (eine p-Dotierung) hineinimplantiert. Somit kann der Gate-Abschirmbereich 16 unterhalb des Trenches gebildet werden.

Das bedeutet, dass mittels eines einfachen Verfahrens gemäß verschiedenen Ausführungsbeispielen der Gate-Abschirmbereich 16 selbstjustiert so gebildet werden kann, dass ein Boden der Finne 14 und Ecken des Trenches geschützt sind.

Beim Dotierprozess zum Bilden des Gate-Abschirmbereichs 16 kann es dazu kommen, dass auch in den Trench-Seitenwänden eine p-dotierte Schicht gebildet wird. Diese kann in verschiedenen Ausführungsbeispielen im anschließenden Finnenbildungsprozess wegoxidiert werden, so dass in der eigentlichen Finne 14 keine p-Dotierung übrigbleibt. Alternativ kann am Rand der Finne 14 eine schmale (z.B. wenige 10 nm dicke) p-dotierte Zone übrigbleiben.

Ein Flächenverhältnis von p-dotiertem Gate-Abschirmbereich 16 zu n-dotiertem Spreadinggebiet 12, ihre Dotierungskonzentrationen und geometrische Anordnung sowie eine Dicke (Tiefe) des Gate-Abschirmbereichs 16 können bestimmt sein durch einen Kompromiss aus Abschirmung (maximales Feld im Gatedielektrikum 32, ausreichend kleiner Kurzschlussstrom und ausreichend hohe Durchbruchspannung) und Leitfähigkeit bei niedrigen (ON-Widerstand). Insbesondere kann in einer Ausführungsform das Spreadinggebiet 12 mehrere unterschiedliche Dotierungskonzentrationen aufweisen, zum Beispiel 2·10¹⁷cm⁻³ unterhalb und um einen unteren Bereich des Abschirmbereichs 16 herum, und 5·10¹⁷cm⁻³ zwischen den Abschirmbereichen unterhalb der Finne 14, was in FIG. 1 als ein optionales zweites Spreadinggebiet 12a eingezeichnet ist, welches beispielsweise bis zur strichpunktierten Linie reicht. Dies kann hilfreich sein, um einen geeigneten Kompromiss zwischen geringem Einschaltwiderstand (hohe Dotierung zwischen den Abschirmbereichen) und hoher Durchbruchspannung (kleine Dotierung unterhalb des Abschirmbereichs) zu finden.

Außerdem kann das Spreadinggebiet 12 in einer Ausführungsform in den unteren Bereich der Finne 14 hineinragen. Insbesondere in den Bereich neben dem elektrisch leitfähigen Bereich 18, 20, der den Gate-Abschirmbereich 16 kontaktiert. Durch eine höhere Dotierung in diesem Bereich ist dieses Gebiet auch bei ausgeschaltetem Gate 24 leitfähig und muss somit vom elektrischen Feld des Gates 24 nicht aufgeschaltet werden.

Der p-dotierte Gate-Abschirmbereich 16 kann in verschiedenen Ausführungsbeispielen direkt durch einen Kontakt im Boden des Trenches - den elektrisch leitfähigen Bereich 18, 20 - an ein Sourcepotential (den Sourcekontakt 28) angeschlossen werden. Der elektrisch leitfähige Bereich 18, 20 kann in verschiedenen Ausführungsbeispielen eine Kontaktschicht 18 (zum Beispiel Nickel-Silizid) aufweisen. Die Kontaktschicht 18, bzw. allgemeiner der elektrisch leitfähige Bereich 18, 20, kann durch ein leitfähiges Material (zum Beispiel ein dotiertes- bzw. in-situ dotiertes Poly-Silizium) an das Source-Metall angeschlossen werden. Vom Gatebereich 24 kann der elektrisch leitfähige Bereich 18, 20 in verschiedenen Ausführungsbeispielen durch eine dielektrische Schicht 22 elektrisch isoliert sein. Die dielektrische Schicht 22 kann in verschiedenen Ausführungsbeispielen eine Oxidschicht sein, die beispielsweise mittels thermischen Oxidierens des elektrisch leitfähigen Bereichs 20 gebildet sein bzw. werden kann, z.B. in einem Fall, dass der elektrisch leitfähige Bereich 20 Polysilizium aufweist. Der (nicht dargestellte) Anschluss an das Source-Metall kann in verschiedenen Ausführungsbeispielen analog zu einem bekannten Vorgehen beim Gate-Anschluss über eine so genannte Superzellen-Hinausführung am Ende des Zellenfeldes verwirklicht werden.

Es kann in verschiedenen Ausführungsbeispielen vorteilhaft sein, eine Herausführung des Anschlusses des Gate-Abschirmbereichs 16 zum Source-Kontakt 28 möglichst kurz zu halten, um den Widerstand zu verkleinern. Dies hat den Vorteil, dass die Entstehung von Joulescher Wärme verringert wird und die Zeitkonstante zum Be- und Entladen des Abschirmungsgebiets klein gehalten wird. Beides erhöht die Leistungseffizienz des Bauteils. Letzteres ist insbesondere zum schnellen Schalten des Bauteils vorteilhaft. Des Weiteren stellt der Strompfad vom Source-Kontakt 28 über den elektrisch leitfähigen Bereich 20, den Abschirmbereich 16 in den Driftbereich 10 eine Diode dar, welche im Diodenbetrieb Strom tragen muss. Daher kann auch für das Funktionieren dieser sogenannten Bodydiode ein geringer Widerstand durch eine kurze Herausführung des Anschlusses des Abschirmbereichs 16 hilfreich sein. In verschiedenen Ausführungsbeispielen kann der elektrisch leitfähige Bereich 18, 20 vollständig aus Metall, z.B. aus Kupfer oder einer Kupferlegierung, gebildet sein bzw. werden. In dem Fall können die Metallschicht 18, 20 und der Gatebereich 24 durch ein (z.B. bei niedrigen Temperaturen) deponiertes Dielektrikum 22 voneinander getrennt werden. Die Metallschicht 18, 20 kann beispielsweise gemäß einem oder in Anlehnung an einen bekannten Damascene-Prozess abgelagert werden bzw. sein. Der FinFET 100 mit dem elektrisch leitfähigen Bereich 18, 20 kann eine erhöhte Robustheit gegenüber hohen Stromdichten aufweisen.

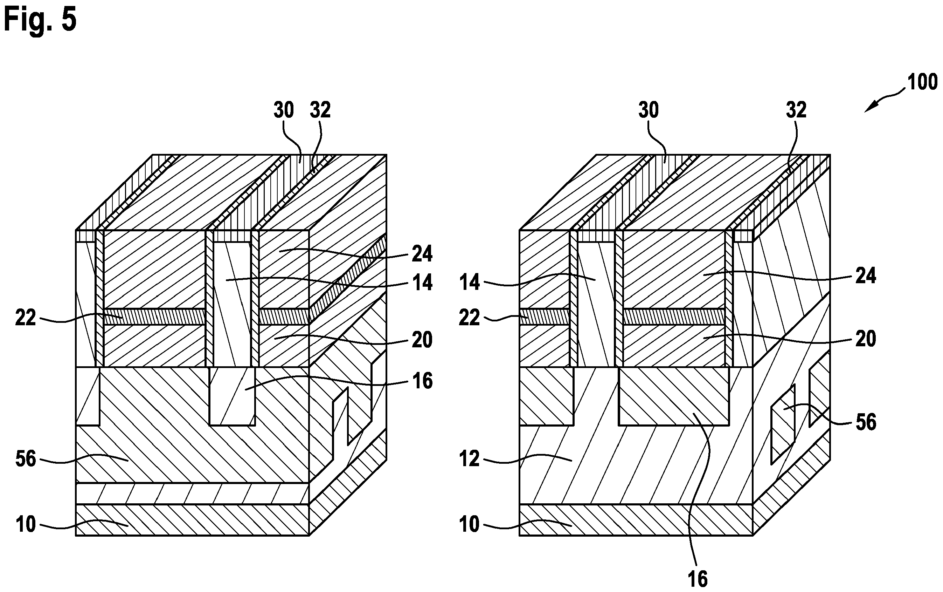

Um eine noch bessere Abschirmung und insbesondere einen höheren Widerstand bei hohen Drain-Spannungen und damit einen geringeren Kurzschlussstrom zu erzielen, kann der vertikale Fin-FET 100, der in FIG. 5 dargestellt ist, in verschiedenen Ausführungsbeispielen ferner eine vergrabene p-dotierte Schicht 56 aufweisen. Die vergrabene p-dotierte Schicht 56 kann in Kontakt sein mit dem Gate-Abschirmgebiet 16. Damit wird die Abschirmung unterhalb des Trenches aus dem Gate-Abschirmgebiet 16 sowie der vergrabenen Schicht 56 zusammensetzt. Somit kann beispielsweise eine Gesamttiefe der Abschirmstruktur 16, 56 in vertikaler Richtung von ca. 1 µm erreicht werden, indem etwa 500 nm Dicke des Gate-Abschirmgebietes 16 mit etwa 500 nm Dicke der vergrabenen Schicht 56 miteinander kombiniert werden, ohne dass der Zell-Pitch P vergrößert werden muss.

In verschiedenen Ausführungsbeispielen kann ferner eine vertikale FinFET-Anordnung bereitgestellt werden, die eine Mehrzahl von vertikalen FinFETs 100 wie oben für verschiedene Ausführungsbeispiele beschrieben aufweist. Das ist in FIG. 1, FIG. 4A bis 4S und FIG. 5 bereits angedeutet durch die Mehrzahl von Finnen 14, Trenches usw.

Die Finnen 14 (und dementsprechend auch die Trenches und die darunter gebildeten Gate-Abschirmbereiche 16) können parallel zueinander angeordnet sein. Sie können eine langgestreckte Geometrie aufweisen und entlang ihrer Längsachsen parallel zueinander angeordnet sein. Die Finnen 14, Trenches und Gate-Abschirmbereiche 16 können sich in einer ersten Richtung erstrecken.

Um Justierungs- (Alignment)-Probleme zwischen der vergrabenen Schicht 56 und den Strukturen der FinFETs 100 zu vermeiden, kann der vergrabene p-dotierte Bereich 56 mindestens einen langgestreckten Bereich, z.B. eine Mehrzahl zueinander paralleler langgestreckter Bereiche 56 aufweisen, welche/r sich in einer zweiten Richtung erstreckt/erstrecken, die von der ersten Richtung verschieden ist. Anders ausgedrückt können die vergrabenen Bereiche 56 in einer Richtung periodisch fortgesetzt sein, die unterschiedlich ist zu der Richtung, in der die Trenches periodisch fortgesetzt sind (siehe zum Beispiel FIG. 5; hier beträgt der Winkel zwischen der ersten Richtung und der zweiten Richtung 90°).

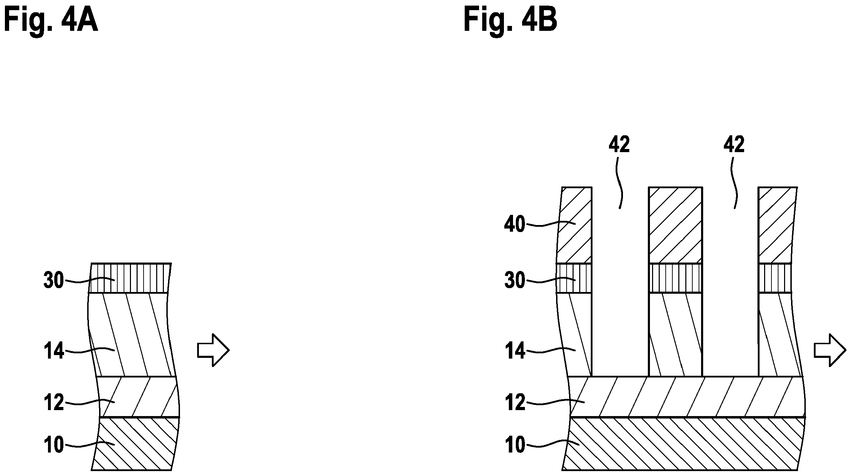

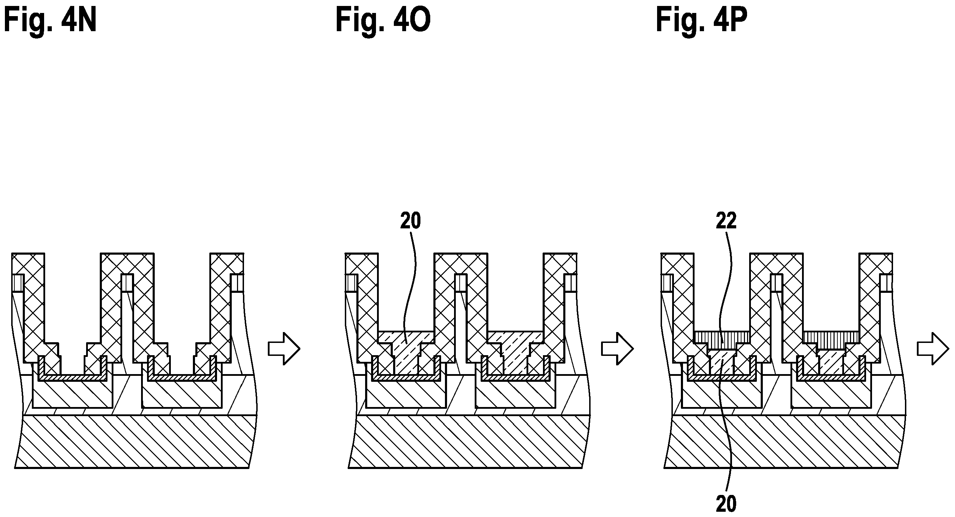

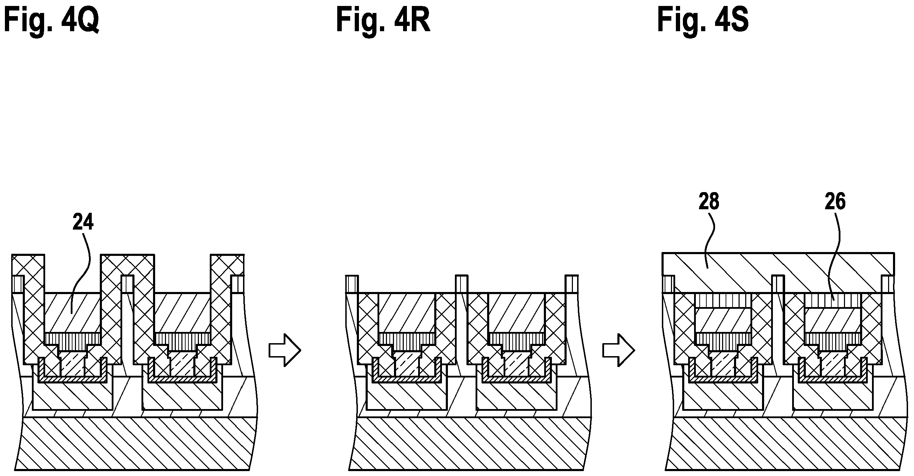

FIG. 4A bis 4S zeigen eine schematische Veranschaulichung eines Verfahrens zum Bilden eines vertikalen FinFETs 100 gemäß einem Ausführungsbeispiel. Eigenschaften von Elementen und sonstigen Merkmalen können dabei dem entsprechen, was oben mit Bezug auf den vertikalen FinFET 100 beschrieben wurde.

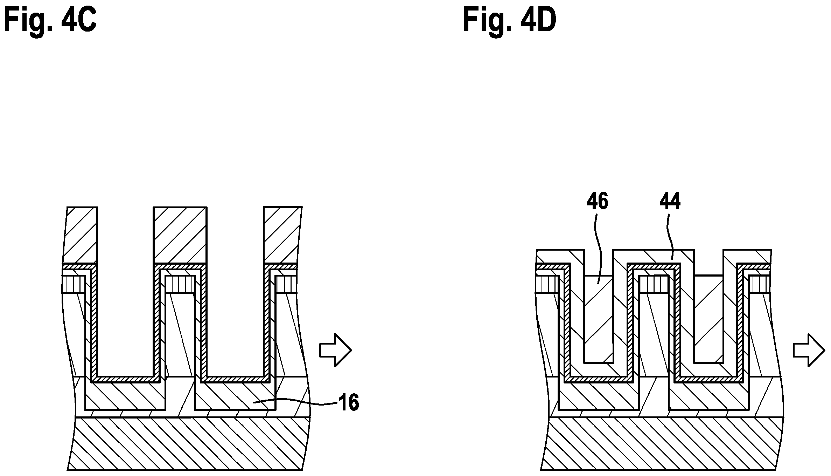

FIG. 4A: Zunächst werden ein n-dotiertes Driftgebiet 10, ein n-dotiertes Spreadinggebiet 12 und ein n-dotiertes Gebiet (aus welchem später die Finne 14 gebildet wird) bereitgestellt, z.B. mittels Epitaxie. In verschiedenen Ausführungsbeispielen kann die Finne 14 in das Spreadinggebiet 12 hineinragen. Sinnvolle Dotierungskonzentrationen können zum Beispiel 10¹⁶ cm⁻³ im Driftgebiet 10, 10¹⁷ cm⁻³ im Spreadinggebiet 12 und 4·10¹⁶ cm⁻³ im Kanalgebiet in der Finne 14 sein. Danach folgt ein flächiger n-Kontakt (Sourcebereich 30), z.B. mit einer Dotierungskonzentration von z.B. 10¹⁹cm⁻³, der entweder in das Kanalgebiet implantiert wird oder auch als epitaktische Schicht bereitgestellt wird. FIG. 4B: Danach werden Trenches 42 mittels eines Ätzprozesses unter Verwendung einer strukturierten Maske 40 (z.B. Oxid-Hartmaske) hergestellt mit Breiten von ca. 800 nm und einer Tiefe von ca. 1,4 µm, welche entweder bis in das Spreadinggebiet 12 hineinreichen oder davor stoppen. Während des Prozesses kann ein Teil der Maske 40 abgetragen werden. FIG. 4C: Die verbleibende restliche Dicke von ca. 800 nm kann als Implantationsmaske verwendet werden und so eine selbstjustierte Implantation des Gate-Abschirmbereichs 16 durch den Trench 42 ermöglicht werden. Eine Implantationstiefe im Trench 42 von ca. 500 nm und eine Dotierung von 5·10¹⁹ cm⁻³ können mit einer 0° Implantation erreicht werden. Anschließend kann die Maske 40 entfernt werden und flächig ein Kontaktmetall 18 (zum Beispiel Nickel) deponiert und einlegiert werden (z.B. NiSi-Kontaktbildung mittels eines etablierten RTA-Prozesses).

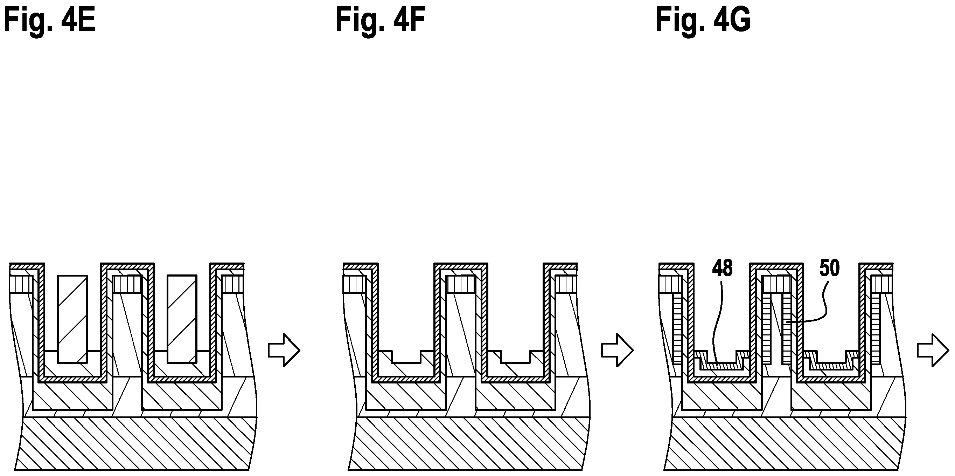

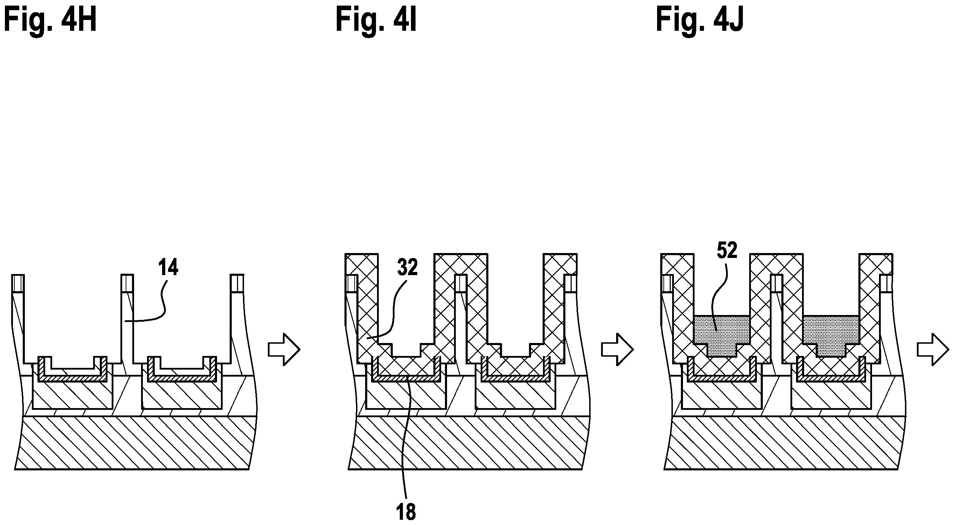

FIG. 4D: Zum Bilden der Finnen 14 kann zunächst ein Schutz für den Trenchboden bereitgestellt werden, indem über eine Si₃N₄ (Bezugszeichen 44) und Poly-Silizium (Bezugszeichen 46) Deposition und Poly-Silizium 46 Rückätzung eine Struktur hergestellt wird (FIG. 4E), die anschließend ein Nassätzen des Si₃N₄ 44 erlaubt, so dass nur am Boden des Trenches Si₃N₄ übrigbleibt (FIG. 4E). Das Poly-Si 46 wird danach ebenfalls entfernt (FIG. 4F). Nun kann, sofern das einlegierte Kontaktmetall oxidierbar ist (z.B. NiSi) durch abwechselnde Oxidation und Oxidätzung der Trench 42 lateral vergrößert werden, so dass am Ende nur noch Finnen 14 zwischen den Trenches 42 übrigbleiben. Bei nicht oxidierbarem Kontaktmetall kann das einlegierte Kontaktmetall vor diesem Schritt (FIG. 4G) selektiv zum Si₃N₄ und zum Wafermaterial (z.B. SiC) entfernt werden (zum Beispiel durch Nassätzung). Da das Si₃N₄ 44 am Trenchboden als Oxidationsbarriere fungiert, weil es deutlich langsamer oxidiert als SiC, bleibt der Kontakt 18 am Boden geschützt. Die Ätzung der oxidierten Bereiche entfernt zugleich auch die oxidierten p-implantierten Bereiche auf der Waferoberfläche und an der Trenchseitenwand, welche unerwünscht sind (FIG. 4G, FIG. 4H). Der Si₃N₄ Schutz 44 am Trenchboden wird anschließend selektiv entfernt und das Gatedielektrikum 32 hergestellt (FIG. 4I).

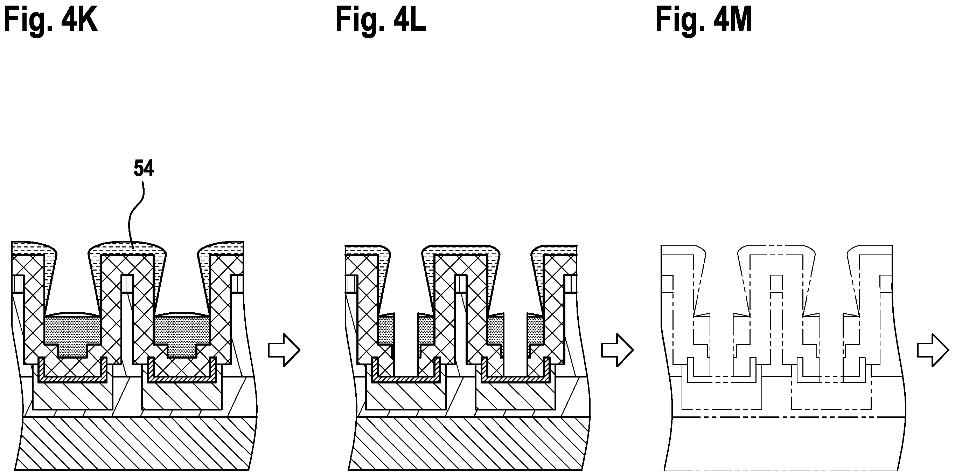

Die Öffnung zum Anschluss der p-Abschirmung 16 benötigt wiederum einige Prozessschritte. FIG. 4J, FIG. 4K: Si₃N₄ kann derart abgeschieden werden (vorzugsweise mittels PECVD oder Sputterdeposition), dass sich an den Finnen 14 Überhänge 54 ergeben. Dies ist eine bekannte Methode mit wohlbekannten Prozessfenstern (Prozessgase, Prozessgasführung, Prozessdruck, Generatorfrequenz und Leistung), um an freistehenden Strukturen bestimmter Aspektverhältnisse oberflächennahe Überhänge 54 auszubilden. Mittels gerichteter Ätzung (unter Ausnutzung von Kollimatoreffekten, zum Beispiel Reaktivem Ionenätzen, RIE, oder Ionenstrahlätzen, IBE) kann dann das Gateoxid 32 im Boden des Trenches 42 geöffnet werden (FIG. 4L). Alternativ kann mit einer Poly-Si-Maske 52 im Trench 42 gearbeitet werden, um das Aspektverhältnis des Trenches 42 zu ändern. Damit können das Ausbilden der Überhänge 54 angepasst und die Trench-Seitenwände besser geschützt werden. Um die Kontaktfläche am Boden des Trenches zu erweitern, kann das Gateoxid 32, welches nur durch den Zugangsbereich am Boden des Trenches 42 geöffnet ist, bei einem optionalen Prozess (FIG. 4M ist deshalb ausgegraut dargestellt) auf Zeit nass geätzt werden, bis der Großteil des Bodens, aber noch nicht die Seitenwand, frei gelegt ist.

Nachdem das Si₃N₄ 54 und ggf. die Poly-Si Maske 52 entfernt sind, können der Kontakt 20 zum Gate-Abschirmbereich 16 und das Gate 24 mitsamt Isolationsschichten 22, 26 in den Trench 42 eingebracht werden (FIG. 4O bis 4S). Dies kann beispielsweise mittels zweifacher Poly-Silizium Deposition, Poly-Silizium Rückätzung, Poly-Silizium Re-Oxidation durchgeführt werden, oder beispielsweise mittels eines Damascene-Prozesses. Zuletzt (FIG. 4S) werden Vorderseitenkontakt 28 und Rückseitenkontakt gebildet. Dazu wurde zuvor (FIG. 4R) das Oxid oberhalb des Sourcebereichs 30 entfernt.

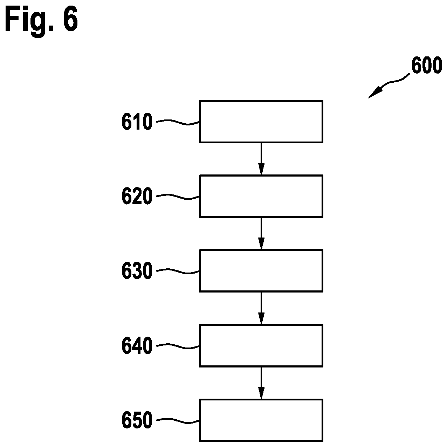

FIG. 6 ist ein Ablaufdiagramm 600 eines Verfahrens zum Bilden eines vertikalen FinFETs gemäß verschiedenen Ausführungsbeispielen.

Das Verfahren kann ein Bilden mehrerer Gräben in einem n-dotierten Halbleiterbereich, derart, dass jeweils zwischen zwei der Gräben eine Halbleiter-Finne mit einem n-dotierten Kanalbereich gebildet wird, welche sich zwischen einem n-dotierten Driftbereich und einem n-dotierten Sourcebereich erstreckt (610), ein p-Dotieren von Halbleiterbereichen am jeweiligen Boden der Gräben zum Bilden p-dotierter Abschirmbereiche (620), ein Bilden einer dielektrischen Schicht auf den Seitenwänden der Gräben (630), ein Anordnen von elektrisch leitfähigem Material, welches in elektrisch leitfähigem Kontakt mit dem jeweiligen darunter angeordneten Abschirmbereich ist, in den Gräben (640) und ein Bilden jeweils eines Gatebereichs in den Gräben über dem elektrisch leitfähigen Material und von diesem elektrisch isoliert aufweisen (650).

## Patentansprüche

1. Vertikaler Fin-Feldeffekttransistor (100), aufweisend:
• eine Halbleiter-Finne (14);
• einen n-dotierten Sourcebereich (30);
• einen n-dotierten Driftbereich (10);
• einen vertikal zwischen dem Sourcebereich (30) und dem Driftbereich (10) angeordneten n-dotierten Kanalbereich in der Halbleiter-Finne (14);
• mindestens einen dem Kanalbereich horizontal benachbarten Gatebereich (24);
• ein Gatedielektrium (32), welches den Gatebereich (24) vom Kanalbereich elektrisch isoliert, wobei eine Grenzflächenschicht zwischen dem Gatedielektrikum (32) und dem Kanalbereich und/oder das Gatedielektrikum (32) negative Grenzflächenladungen aufweist;
• einen p-dotierten Gate-Abschirmbereich (16), welcher so unter dem Gatebereich (24) angeordnet ist, dass bei vertikaler Projektion der Gate-Abschirmbereich (16) zumindest teilweise innerhalb einer vom Gatedielektrikum (32) begrenzten Fläche liegt.
• einen Sourcekontakt (28), welcher elektrisch leitend mit dem Sourcebereich (30) verbunden ist; und
• einen elektrisch leitfähigen Bereich (18, 20) zwischen dem Gatebereich (24) und dem p-dotierten Gate-Abschirmbereich (16);
• wobei der p-dotierte Gate-Abschirmbereich (16) mittels des elektrisch leitfähigen Bereichs (18, 20) mit dem Sourcekontakt (28) elektrisch leitfähig verbunden ist.

2. Vertikaler Fin-Feldeffekttransistor (100) gemäß Anspruch 1,
wobei der elektrisch leitfähige Bereich (18, 20) Polysilizium aufweist, und/oder eine leitfähige Schicht (18) aufweist, die Metall oder ein Nickel-Silizid aufweist.

3. Vertikaler Fin-Feldeffekttransistor (100) gemäß einem der Ansprüche 1 oder 2, wobei die Halbleiter-Finne (14) Siliziumcarbid und/oder Galliumnitrid aufweist.

4. Vertikaler Fin-Feldeffekttransistor (100) gemäß einem der Ansprüche 1 bis 3, wobei der Kanalbereich eine Breite aufweist in einem Bereich von 50 nm bis 400 nm, und wobei eine Dotierungskonzentration im Kanalbereich in einem Bereich von 10¹⁵cm⁻³ bis 10¹⁷cm⁻³ liegt.

5. Vertikaler Fin-Feldeffekttransistor (100) gemäß einem der Ansprüche 1 bis 4, ferner aufweisend:
mindestens ein Spreadinggebiet, (12, 12a) welches höher n-dotiert ist als der Driftbereich (10).

6. Vertikaler Fin-Feldeffekttransistor (100) gemäß Anspruch 5,
wobei das mindestens eine Spreadinggebiet (12, 12a) ein erstes Spreadinggebiet (12) aufweist, welches unterhalb und um einen unteren Bereich des Gate-Abschirmbereichs (16) herum angeordnet ist, und ein zweites Spreadinggebiet (12a) lateral benachbart zum Gate-Abschirmbereich (16) über dem ersten Spreadinggebiet (12), wobei das zweite Spreadinggebiet (12a) höher dotiert ist als das erste Spreadinggebiet (12); und
wobei optional das zweite Spreadinggebiet (12a) in einen unteren Bereich der Finne (14) hineinragt, insbesondere in einen Bereich benachbart zu dem elektrisch leitfähigen Bereich (18, 20).

7. Fin-Feldeffekttransistor-Anordnung, aufweisend:
• eine Mehrzahl von vertikalen Fin-Feldeffekttransistoren (100) gemäß einem der Ansprüche 1 bis 4, welche parallel zueinander angeordnet sind, derart, dass ihre jeweiligen p-dotierten Gate-Abschirmbereiche (16) sich in einer ersten Richtung erstrecken.

8. Fin-Feldeffekttransistor-Anordnung gemäß Anspruch 7, ferner aufweisend:
eine Mehrzahl von vergrabenen p-dotierten Bereichen (56), welche unter den p-dotierten Gate-Abschirmbereichen (16) und in Kontakt mit den p-dotierten Gate-Abschirmbereichen (16) parallel zueinander angeordnet sind und sich in einer zweiten Richtung erstrecken, wobei die zweite Richtung optional verschieden ist von der ersten Richtung.

9. Verfahren zum Bilden eines vertikalen Fin-Feldeffekttransistors, aufweisend:
• Bilden mehrerer Gräben in einem n-dotierten Halbleiterbereich, derart, dass jeweils zwischen zwei der Gräben eine Halbleiter-Finne mit einem n-dotierten Kanalbereich gebildet wird, welche sich zwischen einem n-dotierten Driftbereich und einem n-dotierten Sourcebereich erstreckt (610);
• p-Dotieren von Halbleiterbereichen am jeweiligen Boden der Gräben zum Bilden p-dotierter Abschirmbereiche (620);
• Bilden einer dielektrischen Schicht auf den Seitenwänden der Gräben (630);
• Anordnen von elektrisch leitfähigem Material, welches in elektrisch leitfähigem Kontakt mit dem jeweiligen darunter angeordneten Abschirmbereich ist, in den Gräben (640);
• Bilden jeweils eines Gatebereichs (24) in den Gräben über dem elektrisch leitfähigen Material und von diesem elektrisch isoliert (650).

10. Verfahren gemäß Anspruch 9,
wobei das Anordnen von elektrisch leitfähigem Material ein Bilden einer leitfähigen Schicht aufweist, die Metall oder ein Nickel-Silizid aufweist, und/oder ein Bilden von Polysilizium-Bereichen in den Gräben.

11. Verfahren gemäß Anspruch 9 oder 10, wobei die Gräben sich parallel zueinander in einer ersten Richtung erstrecken, das Verfahren ferner aufweisend:
• Bilden eines unteren n-dotierten Halbleiterbereichs;
• p-Dotieren mindestens eines langgestreckten Bereichs in dem unteren n-dotierten Halbleiterbereich, welcher sich in einer zweiten Richtung erstreckt;
• Bilden des n-dotierten Halbleiterbereichs auf dem unteren n-dotierten Halbleiterbereich und dem langgestreckten Bereich;
• wobei die erste Richtung verschieden ist von der zweiten Richtung; und
• wobei das p-Dotieren der Halbleiterbereiche am jeweiligen Boden der Gräben derart erfolgt, dass die p-dotierten Abschirmbereiche den langgestreckten Bereich kontaktieren.

## Claims

1. Vertical fin field effect transistor (100), comprising:
• a semiconductor fin (14);
• an n-doped source region (30);
• an n-doped drift region (10);
• an n-doped channel region arranged vertically between the source region (30) and the drift region (10) in the semiconductor fin (14);
• at least one gate region (24) horizontally adjacent to the channel region;
• a gate dielectric (32), which electrically insulates the gate region (24) from the channel region, wherein an interface layer between the gate dielectric (32) and the channel region and/or the gate dielectric (32) have/has negative interface charges;
• a p-doped gate shielding region (16) arranged below the gate region (24) such that, in a vertical projection, the gate shielding region (16) lies at least partly within an area delimited by the gate dielectric (32);
• a source contact (28), which is electrically conductively connected to the source region (30); and
• an electrically conductive region (18, 20) between the gate region (24) and the p-doped gate shielding region (16);
• wherein the p-doped gate shielding region (16) is electrically conductively connected to the source contact (28) by means of the electrically conductive region (18, 20) .

2. Vertical fin field effect transistor (100) according to Claim 1,
wherein the electrically conductive region (18, 20) comprises polysilicon, and/or comprises a conductive layer (18) comprising metal or a nickel silicide.

3. Vertical fin field effect transistor (100) according to either of Claims 1 and 2, wherein the semiconductor fin (14) comprises silicon carbide and/or gallium nitride.

4. Vertical fin field effect transistor (100) according to any of Claims 1 to 3, wherein the channel region has a width in a range of 50 nm to 400 nm, and wherein a doping concentration in the channel region lies in a range of 10¹⁵cm⁻³ bis 10¹⁷cm⁻³.

5. Vertical fin field effect transistor (100) according to any of Claims 1 to 4, furthermore comprising:
at least one spreading zone (12, 12a) which is more highly n-doped than the drift region (10).

6. Vertical fin field effect transistor (100) according to Claim 5,
wherein the at least one spreading zone (12, 12a) comprises a first spreading zone (12) arranged below and around a lower region of the gate shielding region (16), and a second spreading zone (12a) laterally adjacent to the gate shielding region (16) over the first spreading zone (12), wherein the second spreading zone (12a) is more highly doped than the first spreading zone (12); and wherein optionally the second spreading zone (12a) projects into a lower region of the fin (14), in particular into a region adjacent to the electrically conductive region (18, 20).

7. Fin field effect transistor arrangement, comprising:
• a plurality of vertical fin field effect transistors (100) according to any of Claims 1 to 4, which are arranged parallel to one another in such a way that their respective p-doped gate shielding regions (16) extend in a first direction.

8. Fin field effect transistor arrangement according to Claim 7, furthermore comprising:
a plurality of buried p-doped regions (56) which are arranged parallel to one another below the p-doped gate shielding regions (16) and in contact with the p-doped gate shielding regions (16) and extend in a second direction, wherein the second direction is optionally different from the first direction.

9. Method for forming a vertical fin field effect transistor, comprising:
• forming a plurality of trenches in an n-doped semiconductor region in such a way that between each two of the trenches a semiconductor fin with an n-doped channel region is formed, said fin extending between an n-doped drift region and an n-doped source region (610);
• p-doping semiconductor regions at the bottom of each of the trenches in order to form p-doped shielding regions (620);
• forming a dielectric layer on the sidewalls of the trenches (630);
• arranging in the trenches electrically conductive material which is in electrically conductive contact with the respective shielding region arranged underneath (640);
• forming a gate region (24) in each of the trenches over the electrically conductive material and electrically insulated therefrom (650).

10. Method according to Claim 9,
wherein arranging electrically conductive material comprises forming a conductive layer comprising metal or a nickel silicide, and/or forming polysilicon regions in the trenches.

11. Method according to Claim 9 or 10, wherein the trenches extend parallel to one another in a first direction, the method furthermore comprising:
• forming a lower n-doped semiconductor region;
• p-doping at least one elongated region in the lower n-doped semiconductor region which extends in a second direction;
• forming the n-doped semiconductor region on the lower n-doped semiconductor region and on the elongated region;
• wherein the first direction is different from the second direction; and
• wherein p-doping the semiconductor regions at the bottom of each of the trenches is effected in such a way that the p-doped shielding regions contact the elongated region.

## Revendications

1. Transistor à effet de champ à ailette verticale (100), présentant :
• une ailette semi-conductrice (14) ;
• une zone de source dopée n (30) ;
• une zone de dérive dopée n (10) ;
• une zone de canal dopée n disposée verticalement entre la zone de source (30) et la zone de dérive (10) dans l'ailette semi-conductrice (14) ;
• au moins une zone de grille (24) horizontalement voisine de la zone de canal ;
• un diélectrique de grille (32) qui isole électriquement la zone de grille (24) par rapport à la zone de canal, dans lequel une couche d'interface entre le diélectrique de grille (32) et la zone de canal et/ou le diélectrique de grille (32) présente(nt) des charges d'interface négatives ;
• une zone de blindage de grille dopée p (16) qui est disposée sous la zone de grille (24) de telle sorte qu'en cas de projection verticale, la zone de blindage de grille (16) se trouve au moins en partie à l'intérieur d'une surface délimitée par le diélectrique de grille (32) ;
• un contact de source (28) qui est relié de manière électriquement conductrice à la zone de source (30) ; et
• une zone électriquement conductrice (18, 20) entre la zone de grille (24) et la zone de blindage de grille dopée p (16) ;
• dans lequel la zone de blindage de grille dopée p (16) est reliée de manière électriquement conductrice au contact de source (28) au moyen de la zone électriquement conductrice (18, 20).

2. Transistor à effet de champ à ailette verticale (100) selon la revendication 1,
dans lequel la zone électriquement conductrice (18, 20) présente du polysilicium et/ou une couche conductrice (18) qui présente du métal ou du siliciure de nickel.

3. Transistor à effet de champ à ailette verticale (100) selon l'une quelconque des revendications 1 ou 2, dans lequel l'ailette semi-conductrice (14) présente du carbure de silicium et/ou du nitrure de gallium.

4. Transistor à effet de champ à ailette verticale (100) selon l'une quelconque des revendications 1 à 3, dans lequel la zone de canal présente une largeur dans une plage de 50 nm à 400 nm, et dans lequel une concentration de dopage dans la zone de canal est comprise dans une plage de 10¹⁵ cm⁻³ à 10¹⁷ cm⁻³.

5. Transistor à effet de champ à ailette verticale (100) selon l'une quelconque des revendications 1 à 4, présentant en outre :
au moins une région de propagation (12, 12a) qui est dopée n plus fortement que la zone de dérive (10).

6. Transistor à effet de champ à ailette verticale (100) selon la revendication 5,
dans lequel ladite au moins une région de propagation (12, 12a) présente une première région de propagation qui est disposée au-dessous et autour d'une zone inférieure de la zone de blindage de grille (16), et une deuxième région de propagation (12a) latéralement voisine de la zone de blindage de grille (16) au-dessus de la première région de propagation (12), la deuxième région de propagation (12a) étant dopée plus fortement que la première région de propagation (12) ; et
dans lequel en option la deuxième région de propagation (12a) fait saillie dans une zone inférieure de l'ailette (14), en particulier dans une zone voisine de la zone électriquement conductrice (18, 20).

7. Agencement de transistor à effet de champ à ailette verticale, présentant :
• une pluralité de transistors à effet de champ à ailette verticale (100) selon l'une quelconque des revendications 1 à 4 qui sont disposés en parallèle les uns aux autres de telle sorte que leurs zones de blindage de grille dopées p (16) respectives s'étendent dans une première direction.

8. Agencement de transistor à effet de champ à ailette verticale selon la revendication 7, présentant en outre :
une pluralité de zones dopées p enterrées (56) qui sont disposées en parallèle les unes aux autres sous les zones de blindage de grille dopées p (16) et en contact avec les zones de blindage de grille dopées p (16) et s'étendent dans une deuxième direction, la deuxième région étant en option différente de la première direction.

9. Procédé de formation d'un transistor à effet de champ à ailette verticale, présentant les étapes consistant à :
• former plusieurs tranchées dans une zone semi-conductrice dopée n de telle sorte que respectivement entre deux des tranchées une ailette semi-conductrice avec une zone de canal dopée n est formée qui s'étend entre une zone de dérive dopée n et une zone de source dopée n (610) ;
• doper p des zones semi-conductrices sur le fond respectif des tranchées pour former des zones de blindage dopées p (620) ;
• former une couche diélectrique sur les parois latérales des tranchées (630) ;
• disposer dans les tranchées (640) un matériau électriquement conducteur qui est en contact électriquement conducteur avec la zone de blindage respective disposée sous celui-ci;
• former respectivement une zone de grille (24) dans les tranchées au-dessus du matériau électriquement conducteur et de manière électriquement isolée (650) par rapport à celui-ci.

10. Procédé selon la revendication 9,
dans lequel la disposition d'un matériau électriquement conducteur présente une formation d'une couche conductrice qui présente du métal ou du siliciure de nickel et/ou une formation de zones de polysilicium dans les tranchées.

11. Procédé selon la revendication 9 ou 10, dans lequel les tranchées s'étendent en parallèle les unes aux autres, le procédé présentant en outre les étapes consistant à :
• former une zone semi-conductrice dopée n inférieure ;
• doper p au moins une zone allongée dans la zone semi-conductrice dopée n inférieure qui s'étend dans une deuxième direction ;
• former la zone semi-conductrice dopée n sur la zone semi-conductrice dopée n inférieure et la zone allongée ;
• dans lequel la première direction est différente de la deuxième direction ; et
• dans lequel le dopage p des zones semi-conductrices est effectué sur le fond respectif des tranchées de telle sorte que les zones de blindage dopées p entrent en contact avec la zone allongée.
